# EUROPÄISCHE PATENTSCHRIFT

(11) **EP 1 619 765 B1**
(45) Veröffentlichungstag und Bekanntmachung des Hinweises auf die Patenterteilung: **20.08.2008**
(21) Anmeldenummer: 04016928.6
(22) Anmeldetag: 19.07.2004
(51) Int. Cl.: H01S 5/40, G02B 27/09, H01S 3/0941, H01S 5/024

(54) **Diodenlaseranordnung und Strahlformungseinheit dafür**
Diode laser arrangement and beam shaping device
Dispositif laser à diodes et unité de mise en forme de faisceau optique

(43) Veröffentlichungstag der Anmeldung: 25.01.2006
(73) Patentinhaber: TRUMPF Laser GmbH + Co. KG, 78713 Schramberg (DE)
(72) Erfinder: Voss, Andreas, 70563 Stuttgart (DE); Liemann, Martin, 78052 Villingen Schwenningen (DE); Dorsch, Friedhelm, 78658 Zimmern o.R. (DE); Wallmeroth, Klaus, 78658 Zimmern (DE); Kumkar, Malte, 78713 Schramberg (DE); Schmitz, Christian, 78655 Dunningen (DE)
(74) Vertreter: Kohler Schmid Möbus

(56) Entgegenhaltungen:
- EP-A- 1 059 713
- WO-A-02/50599
- WO-A-02/056074
- US-A- 4 826 269
- US-A- 6 151 168
- US-A1- 2003 063 639
- US-A1- 2003 099 267

## Beschreibung

Die vorliegende Erfindung betrifft eine Diodenlaseranordnung mit mehreren entlang eines Bogens nebeneinander angeordneten Laserbarren; deren Emissionsrichtungen in das Bogeninnere gerichtet sind.

Eine derartige Diodenlaseranordnung ist beispielsweise durch die US 2003/063639 A1 oder US-A-4 826 269 bekannt geworden.

Als Pumplichtquelle für diodengepumpte Hochleistungsfestkörperlaser dienen z.B. aktiv mit Mikrokanalwärmesenken gekühlte Diodenlaseranordnungen mit vertikalen Laserdiodenstapeln (vertikalen Stacks) aus Laserdiodenbarren. Diese Stacks weisen bei einer ausreichend großen Stapelhöhe (ca. 50 Laserdiodenbarren) ein in etwa gleich großes Strahlparameterprodukt in horizontaler Richtung (Slow-Axis, SA) und in vertikaler Richtung (Fast-Axis, FA) auf. In SA-Richtung ist in jedem Laserbarren eine größere Anzahl an emittierenden Bereichen gleichmäßig verteilt angeordnet. Die Breite eines Barrens in SA-Richtung beträgt typischerweise 10 mm. Die Divergenz der austretenden Laserstrahlung in SA-Richtung liegt bei ca. 6-10° (Vollwinkel). In FA-Richtung emittieren die einzelnen Barren aus einer lediglich ca. 1 µm hohen Apertur mit einer beugungsbedingt hohen Divergenz von ca. 40 - 70° (Vollwinkel). Um eine annähernd bündige Anreihung der emittierten Strahlenbündel bei einem durch die Höhe der aktiven Wärmesenken vorgegebenen Mindestabstand von ca. 1,5 - 2 mm zu erzielen, wird die Strahlung der einzelnen Laserbarren üblicherweise mit Hilfe je einer Mikrozylinderlinse in FA-Richtung kollimiert. Die Ausdehnung der kollimierten Strahlenbündel in FA-Richtung beträgt typischerweise etwa 0,8 - 1 mm. Die Divergenz der kollimierten Strahlenbündel in FA-Richtung liegt, abhängig von der Qualität der Kollimationslinse, der Genauigkeit ihrer Ausrichtung und der Geradheit des Laserbarrens, bei etwa 0,5 - 2° (Vollwinkel). Die vertikale Stapelung der Barren ermöglicht eine einfache Einkopplung der von diesen vertikalen Stacks ausgehenden Strahlung in einen (nahezu) rotationssymmetrischen Lichtmischer unter annähernder Beibehaltung der Brillanz der Pumpstrahlung. Im Lichtmischer wird die Pumpstrahlung z.B. durch Mehrfachreflexion homogenisiert. Die aus dem Lichtmischer austretende Strahlung eignet sich zur Abbildung eines runden Pumpflecks auf einen Laserkristall. Nachteilig ist allerdings die begrenzte Lebenserwartung der aktiv gekühlten, vertikalen Stacks von ca. 10000 h.

Aus der DE 100 61 265 A1 sind quasi-passiv gekühlte Diodenlaseranordnungen mit horizontalen Laserdiodenstapeln (2D-Passiv-Stack, horizontaler Stack) als Pumplichtquelle für Hochleistungsfestkörperlaser bekannt. Bei diesen Diodenlaseranordnungen sind die einzelnen Laserbarren nicht in FA-Richtung übereinander, sondern in SA-Richtung nebeneinander und - in einer besonders vorteilhaften Anordnung - in FA-Richtung leicht stufig zueinander versetzt angeordnet. Die horizontalen Stacks weisen durch die Trennung der elektrischen Funktion von der Kühlung sowie aufgrund der größeren Kühlstrukturen und der stark reduzierten Zahl an Dichtungselementen eine wesentlich erhöhte Zuverlässigkeit gegenüber den vertikalen Stacks auf.

Die für die horizontalen Stacks erforderliche Kühlstruktur ist aus der DE 102 29 711 A1 bekannt. Die Laserbarren werden zunächst auf (passiven) Kupfer-Wärmesenken montiert. Mehrere (typischerweise 4 bis 12) der Wärmesenken, auf denen die Barren montiert sind, werden anschließend auf einen gemeinsamen aktiven Kühler gelötet. Der aktive Kühler besteht aus zwei (oder mehr) Platten aus thermisch leitfähiger Keramik, zwischen denen mehrere Schichten aus Kupfer mit eingefrästen oder geätzten Kühlkanälen angeordnet sind. Die Schichten werden miteinander und mit den Keramikplatten durch das sog. Direct-Copper-Bond-Verfahren verbunden. Die Kühlkanäle sind breiter und die Kühlfläche ist größer als bei herkömmlich gekühlten vertikalen Stacks, so dass das Kühlwasser langsamer fließen kann und weniger Probleme durch Abrasion der Kühlkanäle auftreten.

Nachteilig ist das optische Format, das sich durch in SA-Richtung nebeneinander aufgereihte Laserdiodenbarren ergibt. Im Gegensatz zum vertikalen Stack wird beim horizontalen Stack die Asymmetrie der Strahlqualität durch die nebeneinander angeordneten Barren und die daraus resultierende Verbreiterung des Gesamtquerschnitts der emittierten Strahlung entlang der SA-Richtung noch weiter erhöht. Außerdem sind aufgrund der vergleichsweise großen Bauhöhe der horizontalen Stacks in FA-Richtung für eine optisch bündige Stapelung in FA-Richtung FA-Kollimatorlinsen mit ungewöhnlich großer Brennweite erforderlich. Die geringe Divergenz der so kollimierten Strahlen erfordert eine sehr hohe Genauigkeit der optischen Komponenten im weiteren Strahlengang. Weiterhin ergibt sich eine für praktische Anwendungen zu große Gesamthöhe bei der für symmetrische Strahlqualität erforderlichen Anzahl gestapelter horizontaler Stacks. Daher ist zur Erzielung einer annähernden Symmetrie der Ausgangsstrahlung von horizontalen Stacks eine Strahlformungseinheit notwendig, die die in SA-Richtung nebeneinander verlaufenden Strahlen eines horizontalen Stacks in in FA-Richtung übereinander verlaufende Strahlen umordnet.

Aus der EP 1 059 713 A2 ist eine Strahlformungseinheit zur Erzeugung eines Laserstrahls mit symmetrischer Brightness aus mehreren, von den einzelnen Dioden eines Laserdiodenbarrens emittierten, parallelen und in SA-Richtung lateral versetzen Laserstrahlen bekannt. In einer Variante weist die Strahlformungsoptik ein erstes transmissives optisches Element zur lateralen Versetzung der einzelnen Laserstrahlen in FA-Richtung auf. Ein zweites transmissives optisches Element lenkt die Laserstrahlen in der von SA-Richtung und Strahlrichtung gebildeten Ebene derart um, dass diese auf eine gemeinsame Schnittachse in FA-Richtung zulaufen. Die Richtungen der einlaufenden Laserstrahlen entlang der Schnittachse unterscheiden sich, sodass dort ein Fächerspiegel mit einer der Zahl der Laserstrahlen entsprechenden Zahl von zueinander verdrehten, in FA-Richtung übereinander gestapelten Einzelspiegeln vorgesehen ist, der die Laserstrahlen in eine gemeinsame Emissionsrichtung umlenkt.

Aus der eingangs genannten US 2003/063639 A1 ist eine Diodenlaseranordnung bekannt, bei der die Pumpstrahlen von Laserdiodenbarren, die in ihrer FA-Richtung entlang eines Zylinders ausgerichtet sind, direkt in einen Laserstab fokussiert werden. Der Laserstab befindet sich im Mittelpunkt des Zylinders und ist mit seiner Mittelachse senkrecht zur Ausbreitungsrichtung der Pumpstrahlung ausgerichtet. Die Laserbarren sind zum Pumpen des Laserstabs in FA-Richtung bogenförmig angeordnet, da sich die FA-Richtung des ausgesandten Pumpstrahls gut fokussieren und damit direkt transversal in den Laserstab richten lässt.

Aus der ebenfalls eingangs genannten US-A-4 826 269 ist eine Anordnung von Laserdiodenbarren beschrieben, die jeweils in ihrer FA-Richtung entlang eines Bogens angeordnet sind. Die von den einzelnen Barren ausgehende Strahlung wird in einem Fokuspunkt bzw. einer Fokusebene fokussiert, um dort eine hohe Leistungsdichte zu erreichen.

Demgegenüber ist es die Aufgabe der vorliegenden Erfindung, eine Diodenlaseranordnung der eingangs genannten Art dahingehend weiterzubilden, dass eine Verkämmung in einer nachfolgenden Strahlformungseinheit ohne ein zusätzliches, einen Lateralversatz in FA-Richtung erzeugendes optisches Element möglich ist.

Diese Aufgabe wird erfindungsgemäß dadurch gelöst, dass die Laserbarren mit ihrer SA-Richtung entlang des Bogens angeordnet sind und dass zumindest einige, vorzugsweise alle Laserbarren gegenüber allen in Bogenrichtung jeweils benachbarten Laserbarren in ihrer FA-Richtung versetzt sind und/oder die Emissionsrichtungen von zumindest einigen, vorzugsweise allen Laserbarren in ihrer FA-Richtung gegeneinander verkippt sind.

Die Emissionsrichtungen der Laserbarren verlaufen vorzugsweise konvergent, d.h. auf einen gemeinsamen Mittelpunkt zu. Hierdurch kann in einer nachfolgenden Strahlformungsoptik auf die Verwendung von optischen Elementen zur Zusammenführung der Laserstrahlen verzichtet werden. Insbesondere können die bei Verwendung transmissiver optischer Elemente durch Erhitzung dieser Elemente auftretenden thermischen Probleme vermieden werden. Durch Versetzung der Laserbarren in FA-Richtung ist eine Verkämmung in einer nachfolgenden Strahlformungseinheit ohne ein zusätzliches, einen Lateralversatz in FA-Richtung erzeugendes optisches Element möglich. Durch die Verkippung der Emissionsrichtungen kann auf einfache Weise ein Versatz der Laserstrahlen in der FA-Richtung erzeugt werden. Auf den lateralen Versatz der Barren in FA-Richtung kann so verzichtet werden. Die Laserstrahlen verlaufen in diesem Fall in FA-Richtung nicht mehr parallel, was aber in einer nachfolgenden Strahlformungsoptik ausgeglichen werden kann. Die Verkippung der Emissionsrichtungen der Laserbarren kann durch eine gegeneinander verkippte Anordnung der Laserbarren erreicht werden.

In einer vorteilhaften Weiterbildung sind zumindest einige, vorzugsweise alle Laserbarren treppenförmig zueinander versetzt.

In einer Weiterbildung der Erfindung ist im Strahlengang nach den zumindest einigen, vorzugsweise allen Laserbarren mindestens ein erstes optisches Element, insbesondere eine Zylinderlinse, zur Verkippung der Emissionsrichtungen angeordnet. Das optische Element kann entweder als einzelne Zylinderlinse ausgeführt sein, die sich in ihrer Ausdehnung über alle Laserbarren erstreckt und die in der zur Strahlausbreitungsrichtung senkrechten Ebene zu den Laserbarren verdreht angeordnet ist, so dass die Strahlrichtung der zuvor kollimierten Laserstrahlen geändert wird. Alternativ kann nach allen Laserbarren jeweils eine Zylinderlinse angeordnet sein, die gleichzeitig zur Kollimation der von den Laserbarren emittierten Laserstrahlen in FA-Richtung dient. Durch eine geringfügige Verschiebung der Zylinderlinsen in FA-Richtung lässt sich die Verkippung der Emissionsrichtungen erreichen.

In einer besonders bevorzugten Weiterbildung sind zumindest einige, vorzugsweise alle Laserbarren entlang eines Kreisbogens oder eines Zylindermantelsegments angeordnet und ihre Emissionsrichtungen etwa auf den Mittelpunkt des Kreisbogens oder etwa auf die Achse des Zylindermantelsegments ausgerichtet. Die optische Weglänge, die von den Laserstrahlen auf ihrem Weg zum Mittelpunkt bzw. zur Achse zurückgelegt wird, ist annähernd gleich. Hierdurch wird die Erzeugung eines nach der Verkämmung gebildeten Laserstrahls mit einheitlicher Strahldivergenz erleichtert. Insbesondere ist es leicht möglich, die Strahlaustrittsöffnung der verschiedenen Laserbarren in SA-Richtung in einer gemeinsamen Ebene (z.B. der Eintrittsöffnung eines Lichtmischers) annähernd scharf abzubilden.

Bei einer besonders bevorzugten Ausführungsform sind zumindest einige, vorzugsweise alle Laserbarren auf einem gemeinsamen Kühlkörper angebracht. Die Laserbarren können auf dem gemeinsamen Kühlkörper fixiert und gemeinsam gekühlt werden.

Vorzugsweise sind die einzelnen Laserbarren auf individuellen, identischen, passiven Wärmesenken, insbesondere aus Kupfer, angebracht, die auf dem gemeinsamen, aktiven Kühlkörper fixiert werden. Die bogenförmige Anordnung und der laterale Versatz bzw. die Verkippung der Laserbarren in FA-Richtung werden durch auf dem Kühlkörper angebrachte (z.B. gefräste) Auflageflächen realisiert. Die Form der Wärmesenken und der Auflageflächen ist so gestaltet, dass annähernd gleiche thermische Weglängen zwischen den einzelnen Laserbarren und dem Kühlkörper erreicht werden.

Bevorzugt weist die erfindungsgemäße Diodenlaseranordnung mindestens eine die Emissionsrichtungen der Laserbarren zu einer gemeinsamen Emissionsrichtung zusammenführende Optik auf. Durch die Verwendung der erfindungsgemäßen Diodenlaseranordnung mit konvergentem Strahlengang muss die Optik die Emissionsrichtungen der einlaufenden Laserstrahlen in der SA-Richtung lediglich umlenken, nicht jedoch lateral versetzen.

Wenn zumindest einige, vorzugsweise alle Laserbarren entlang eines Kreisbogens oder eines Zylindermantelsegments angeordnet und ihre Emissionsrichtungen etwa auf den Mittelpunkt des Kreisbogens oder etwa auf die Achse des Zylindermantelsegments ausgerichtet sind, ist die Optik vorzugsweise eine in der Nähe des Mittelpunkts oder der Achse angeordnete Reflektoroptik. Durch die Verwendung einer Reflektoroptik kann die Anzahl an optischen Flächen im Vergleich zu einer transmissiven Optik stark vermindert werden.

Bei einer weiteren bevorzugten Ausführungsform weist die Reflektoroptik entlang der Achse des Zylindermantelsegments für jede Emissionsrichtung der Laserbarren einen Einzelspiegel, insbesondere einen Planspiegel oder einen konkaven Zylinderspiegel, auf, wobei die Einzelspiegel jeweils um einen Winkel zur Achse des Zylindermantelsegments gegeneinander verdreht sind. Der Winkel, den jeder der Einzelspiegel mit der jeweiligen Emissionsrichtung des zugeordneten Laserbarrens einschließt, wird so gewählt, dass im Strahlengang hinter der Reflektoroptik ein Laserstrahl mit einer einzigen Emissionsrichtung entsteht. Typischerweise wird hierbei eine fächerförmige Anordnung der Einzelspiegel erzeugt. Durch Verwendung von konkaven Zylinderspiegeln kann eine Kollimation entlang der SA-Richtung erzeugt werden, wenn die effektive Brennweite der Zylinderspiegel in etwa dem Abstand zwischen den Laserbarren und der Reflektoroptik entspricht. Hierdurch kann auf die Einbringung einer Zylinderlinse in den nachfolgenden Strahlengang zu diesem Zweck verzichtet werden. Der Umlenkwinkel, den die auf den Fächerspiegel ein- und auslaufenden Laserstrahlen miteinander einschließen, ist in diesem Fall möglichst klein gewählt, um Abbildungsfehler zu vermeiden.

In einer Weiterbildung sind die Einzelspiegel der Reflektoroptik in FA-Richtung gegeneinander verkippt angeordnet, um aus in FA-Richtung nicht parallel zueinander einlaufenden Laserstrahlen parallel zueinander auslaufende Teilstrahlen eines Laserstrahls mit einer einzigen Emissionsrichtung zu erzeugen.

Bei einer weiteren besonders bevorzugten Ausführungsform sind die Einzelspiegel zu einer monolithisch oder quasi-monolithisch ausgebildeten Spiegelanordnung zusammengefügt. Eine solche Anordnung ist kostengünstig und mit hoher Präzision herstellbar. Als Material für die Einzelspiegel bzw. die Spiegelanordnung kommt vorzugsweise diamantgefrästes Kupfer oder Glas mit einer hochreflektierenden, dielektrischen Beschichtung in Frage.

Bei einer weiteren bevorzugten Ausführungsform ist die Reflektoroptik durch ein diffraktives optisches Element gebildet, das fotolithographisch hergestellt werden kann und z.B. als planares, monolithisches Gitter ausgeführt sein kann.

Weitere Vorteile der Erfindung ergeben sich aus der Beschreibung und der Zeichnung. Ebenso können die vorstehend genannten und die noch weiter aufgeführten Merkmale je für sich oder zu mehreren in beliebigen Kombinationen Verwendung finden. Die gezeigten und beschriebenen Ausführungsformen sind nicht als abschließende Aufzählung zu verstehen, sondern haben vielmehr beispielhaften Charakter für die Schilderung der Erfindung.

Es zeigen:
- Fig. 1: eine erste Ausführungsform der erfindungsgemäßen Strahlformungseinheit mit einer Diodenlaseranordnung in einer Draufsicht;
- Fig. 2: die Diodenlaseranordnung von Fig. 1 in einer Frontalansicht; und
- Fig. 3: eine Seitenansicht einer zweiten Ausführungsform der erfindungsgemäßen Strahlformungseinheit.

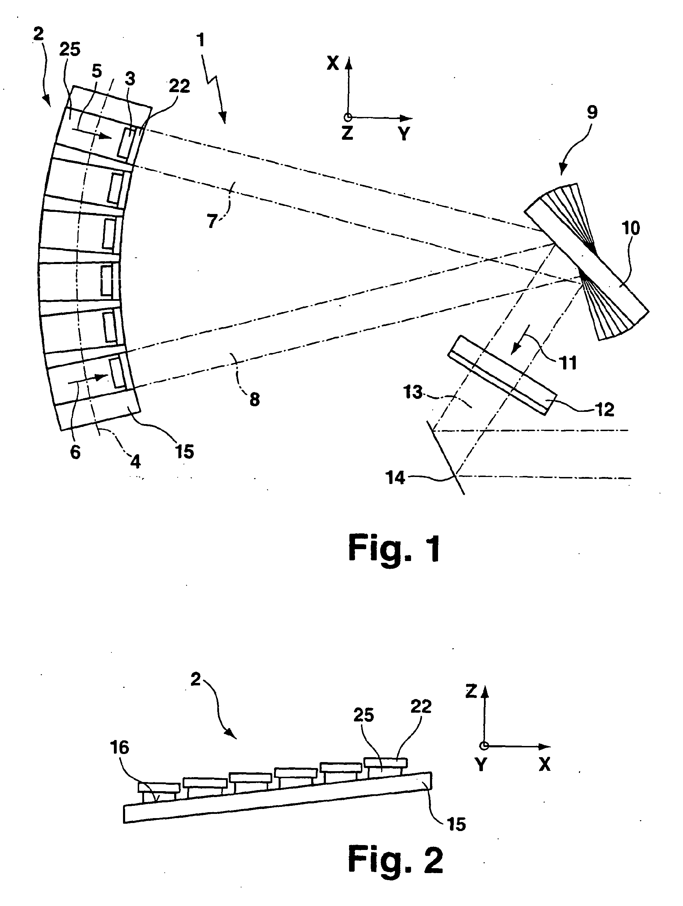

Die in **Fig. 1** in einer Draufsicht gezeigte Strahlformungseinheit **1** umfasst eine Diodenlaseranordnung **2** mit sechs Laserbarren **3**, welche auf einem in der **XY-**Ebene eines XYZ-Koordinatensystems liegenden Kreisbogen **4** angeordnet und in **Z-**Richtung lateral zueinander versetzt angeordnet sind. Die Laserbarren sind auf Wärmesenken aus Kupfer **25** und einem gemeinsamen Kühlkörper **15** angebracht. Die SA-Richtungen der von den Laserbarren 3 emittierten Laserstrahlen, von denen ein erster **7** und ein zweiter **8** in der Fig. 1 gezeigt sind, verlaufen in der XY-Ebene, die FA-Richtung in der zu dieser rechtwinkligen Z-Richtung. Am Strahlaustritt jedes Laserbarrens befindet sich eine Zylinderlinse **22** zur Kollimation der emittierten Laserstrahlen in FA-Richtung und ggf. zur Verkippung der emittierten Laserstrahlen in FA-Richtung.

Jeder der Laserbarren 3 weist eine Emissionsrichtung auf, von denen eine erste **5** und eine zweite **6** in der Fig. 1 gezeigt sind. In der XY-Ebene schneiden sich die Emissionsrichtungen 5, 6 der Laserbarren im Mittelpunkt des Kreisbogens. In der Nähe des Mittelpunkts des Kreisbogens 4 ist eine Reflektoroptik (Fächerspiegel) **9** mit sechs in Z-Richtung übereinander gestapelten Einzelspiegeln **10** angeordnet, welche um einen jeweils identischen Winkel um die Z-Richtung gegeneinander verdreht sind, sodass eine fächerförmige Anordnung entsteht. Die Einzelspiegel 10 sind als Planspiegel ausgeführt, und ihre Oberflächen sind unter solchen Winkeln gegenüber den Emissionsrichtungen 5, 6 der Laserbarren 3 angeordnet, dass durch Reflexion eine einzige (gemeinsame) Emissionsrichtung **11** gebildet wird. Die in Z-Richtung zueinander lateral versetzten Laserstrahlen 7, 8 werden auf diese Weise zu einem gemeinsamen Laserstrahl **13** vereinigt. Die einzelnen Laserstrahlen verlaufen nach der Reflektoroptik nicht mehr radial nebeneinander, sondern parallel übereinander.

Der gemeinsame Laserstrahl 13 kann entlang der Z-Richtung (FA-Richtung) durch eine im Strahlengang nachfolgende Zylinderlinse **12** fokussiert werden. Alternativ kann die Fokussierung auch direkt durch den Fächerspiegel, d.h. durch in FA-Richtung verkippt angeordnete Einzelspiegel, erfolgen.

Ein ebenfalls optionaler Umlenkspiegel **14** sorgt dafür, dass der gemeinsame Laserstrahl 13 im Wesentlichen in eine zu den Emissionsrichtungen 5, 6 der Laserbarren 3 annähernd parallele Richtung umgelenkt wird. Durch eine konkav zylindrische Ausführung des Umlenkspiegels 14 wird eine gleichzeitige Umlenkung und Fokussierung des Laserstrahis 13 ermöglicht, so dass auf die Zylinderlinse 12 verzichtet werden kann.

Durch eine weitere im Strahlengang nachfolgende Zylinderlinse oder einen weiteren zylindrischen Spiegel kann der Laserstrahl 13 auch in X-Richtung (SA-Richtung) fokussiert werden. So weist der Laserstrahl 13 in einer im Strahlengang nach der Reflektoroptik befindlichen Ebene zugleich in X- und in Z-Richtung eine annähend minimale Höhe auf. In dieser Ebene kann die Eintrittsöffnung eines Lichtmischers angeordnet werden.

**Fig. 2** zeigt die Diodenanordnung 2 von Fig. 1 in einer Frontalansicht. Die Laserbarren 3 sind mit ihren Wärmesenken 25 auf einem gemeinsamen Kühlkörper 15 angeordnet, welcher schräg zur XY-Ebene positioniert ist. Auflageflächen 16 für die Wärmesenken 25 sind auf dem Kühlkörper 15 beispielsweise durch Ausfräsen einer auf dem Kühlkörper 15 aufgebrachten Kupferschicht gebildet. Der Kühlkörper 15 ist z.B. wie in der DE 102 29 711 A1 beschrieben ausgebildet.

Die Strahlformungseinheit 1 kann eine Anzahl von entlang der Z-Richtung übereinander angeordneten Diodenanordnungen 2 sowie eine entsprechende Anzahl von Reflektoroptiken 9 aufweisen, wobei diese Anzahl so gewählt ist, dass der gemeinsame Laserstrahl 13 im Wesentlichen bezüglich der Strahlqualität symmetrisch ist.

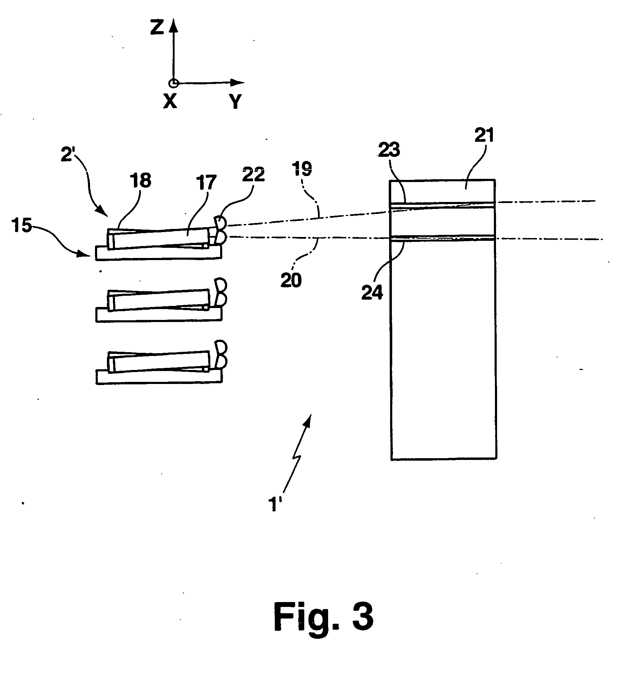

**Fig. 3** zeigt eine weitere Strahlformungseinheit **1**' in einer Seitenansicht, welche drei entlang der Z-Richtung lateral versetzt angeordnete Diodenlaseranordnungen **2**' aufweist, die jeweils sechs Laserbarren umfassen, von denen jeweils ein erster **17** und ein zweiter **18** gezeigt sind. Die Laserbarren 17, 18 sind in der XY-Ebene entlang eines Kreisbogens angeordnet und in Z-Richtung gegeneinander verkippt, so dass die von den Laserbarren 17, 18 ausgehenden Laserstrahlen **19, 20** gegeneinander verkippt sind. Dadurch treffen die Laserstrahlen 19, 20 auf zwei unterschiedliche Einzelspiegel **23, 24** einer Reflektoroptik **21** und werden von diesen in der XY-Ebene um einen unterschiedlichen Winkel umgelenkt, sodass sie übereinandergeschoben werden. Die parallele Ausrichtung der reflektierten Strahlenbündel in FA-Richtung (Z-Richtung) wird durch eine nicht dargestellte leichte Verkippung der Einzelspiegel in Z-Richtung (um die X-Achse) erreicht.

## Patentansprüche

1. Diodenlaseranordnung (2; 2') mit mehreren entlang eines Bogens nebeneinander angeordneten Laserbarren (3; 17, 18), deren Emissionsrichtungen (5, 6) in das Bogeninnere gerichtet sind,
**dadurch gekennzeichnet,**
**dass** die Laserbarren (3; 17, 18) mit ihrer SA-Richtung entlang des Bogens angeordnet sind und dass zumindest einige, vorzugsweise alle Laserbarren (3; 17, 18) gegenüber allen in Bogenrichtung jeweils benachbarten Laserbarren in ihrer FA-Richtung (Z) versetzt sind und/oder die Emissionsrichtungen von zumindest einigen, vorzugsweise allen Laserbarren (3; 17, 18) in ihrer FA-Richtung (Z) gegeneinander verkippt sind.

2. Diodenlaseranordnung nach Anspruch 1, **dadurch gekennzeichnet, dass** zumindest einige, vorzugsweise alle Laserbarren (3; 17, 18) in ihrer FA-Richtung (Z) treppenförmig zueinander versetzt sind.

3. Diodenlaseranordnung nach Anspruch 1 oder 2, **dadurch gekennzeichnet, dass** im Strahlengang nach den zumindest einigen, vorzugsweise allen Laserbarren (3; 17,18) mindestens ein erstes optisches Element, insbesondere eine Zylinderlinse (22), zur Verkippung der Emissionsrichtungen angeordnet ist.

4. Diodenlaseranordnung nach einem der vorhergehenden Ansprüche, **dadurch gekennzeichnet, dass** zumindest einige, vorzugsweise alle Laserbarren (3; 17, 18) entlang eines Kreisbogens (4) oder eines Zylindermantelsegments angeordnet und ihre Emissionsrichtungen (5, 6) etwa auf den Mittelpunkt des Kreisbogens (4) oder etwa auf die Achse des Zylindermantelsegments ausgerichtet sind.

5. Diodenlaseranordnung nach einem der vorhergehenden Ansprüche, **dadurch gekennzeichnet, dass** zumindest einige, vorzugsweise alle Laserbarren (3; 17, 18) auf einem gemeinsamen Kühlkörper (15) angebracht sind.

6. Diodenlaseranordnung nach Anspruch 5, **dadurch gekennzeichnet, dass** die Verbindung zwischen den Laserbarren (3; 17,18) und dem Kühlkörper (15) über identische Wärmesenken (25), insbesondere aus Kupfer, hergestellt ist.

7. Diodenlaseranordnung nach Anspruch 5 oder 6, **dadurch gekennzeichnet, dass** der Kühlkörper für jeden seiner Laserbarren (3; 17, 18) eine Auflagefläche umfasst, wobei insbesondere zumindest einige der Auflageflächen gegeneinander verkippt sind.

8. Diodenlaseranordnung nach Anspruch 6 oder 7, **dadurch gekennzeichnet, dass** durch die Form der Auflageflächen und/oder der Wärmesenken annähernd gleiche thermische Weglängen zwischen den Laserbarren (3; 17, 18) und dem Kühlkörper (15) für alle Laserbarren (3; 17, 18) festgelegt sind.

9. Diodenlaseranordnung nach einem der vorhergehenden Ansprüche, **gekennzeichnet durch** mindestens eine die Emissionsrichtungen (5, 6) der Laserbarren (3; 17, 18) zu einer gemeinsamen Emissionsrichtung (11) zusammenführende Optik (9, 21).

10. Diodenlaseranordnung nach Anspruch 9, **dadurch gekennzeichnet, dass** zumindest einige, vorzugsweise alle Laserbarren (3; 17, 18) entlang eines Kreisbogens (4) oder eines Zylindermantelsegments angeordnet und ihre Emissionsrichtungen (5, 6) etwa auf den Mittelpunkt des Kreisbogens (4) oder etwa auf die Achse des Zylindermantelsegments ausgerichtet sind und dass die Optik (9, 21) eine in der Nähe des Mittelpunkts des Kreisbogens (4) oder der Achse des Zylindermantelsegments der Emissionsrichtungen (5, 6) angeordnete Reflektoroptik ist.

11. Diodenlaseranordnung nach Anspruch 10, **dadurch gekennzeichnet, dass** die Reflektoroptik (9, 21) entlang der Achse des Zylindermantelsegments für jede Emissionsrichtung (5, 6) einen Einzelspiegel (10; 23, 24), insbesondere einen Planspiegel oder einen konkaven Zylinderspiegel, aufweist, wobei die Einzelspiegel (10; 23, 24) jeweils um einen Winkel zur Achse des Zylindermantelsegments gegeneinander verdreht sind.

12. Diodenlaseranordnung nach Anspruch 11, **dadurch gekennzeichnet, dass** die Einzelspiegel (23, 24) in der FA-Richtung (Z) gegeneinander verkippt sind.

13. Diodenlaseranordnung nach Anspruch 11 oder 12, **dadurch gekennzeichnet, dass** die Einzelspiegel (10; 23, 24) zu einer monolithisch oder quasi-monolithisch ausgebildeten Spiegelanordnung zusammengefügt sind.

14. Diodenlaseranordnung nach einem der Ansprüche 11 bis 13, **dadurch gekennzeichnet, dass** die Einzelspiegel (10; 23, 24) oder die Spiegelanordnung aus diamantgefrästem Kupfer oder aus dielektrisch hochreflektierend beschichtetem Glas bestehen.

15. Diodenlaseranordnung nach Anspruch 10. **dadurch gekennzeichnet, dass** die Reflektoroptik durch ein diffraktives optisches Element gebildet ist.

## Claims

1. Diode laser configuration (2; 2') comprising several laser bars (3; 17, 18) which are disposed next to each other along an arc, with their emission directions (5, 6) being directed towards the inside of the arc,
**characterized in that** the laser bars (3; 17, 18) are disposed such that their SA direction extends along the arc and at least some, preferably all laser bars (3; 17, 18), are offset in their FA direction (Z) with respect to their respectively neighboring laser bars in the direction of the arc and/or the emission directions of at least some, preferably all laser bars (3; 17, 18) are tilted with respect to each other in their FA direction (Z).

2. Diode laser configuration according to claim 1, **characterized in that** at least some, preferably all laser bars (3; 17, 18) are offset relative to each other like stairs in their FA direction (Z).

3. Diode laser configuration according to claim 1 or 2, **characterized in that** at least one first optical element, in particular a cylindrical lens (22), is disposed in the path of rays downstream of at least some, preferably all laser bars (3; 17, 18), for tilting the emission directions.

4. Diode laser configuration according to any one of the preceding claims, **characterized in that** at least some, preferably all laser bars (3; 17, 18), are disposed along a circular arc (4) or a cylinder jacket segment, with their emission directions (5, 6) being oriented approximately to the center of the circular arc (4) or approximately to the axis of the cylinder jacket segment.

5. Diode laser configuration according to any once of the preceding claims, **characterized in that** at least some, preferably all laser bars (3; 17, 18), are disposed on a common cooling body (15).

6. Diode laser configuration according to claim 5, **characterized in that** the connection between the laser bars (3; 17, 18) and the cooling body (15) is realized through identical heat sinks (25), in particular of copper.

7. Diode laser configuration according to claim 5 or 6, **characterized in that** the cooling body comprises a contact surface for each laser bar (3; 17, 18) thereof, wherein, in particular, at least some of the contact surfaces are tilted with respect to each other.

8. Diode laser configuration according to claim 6 or 7, **characterized in that** the shape of the contact surfaces and/or heat sinks define approximately identical thermal path lengths between the laser bars (3; 17, 18) and the cooling body (15) for all laser bars (3; 17, 18).

9. Diode laser configuration according to any one of the preceding claims, **characterized by** at least one optics (9, 21) for merging the emission directions (5, 6) of the laser bars (3; 17, 18) into a common emission direction (11).

10. Diode laser configuration according to claim 9, **characterized in that** at least some, preferably all laser bars (3; 17, 18) are disposed along a circular arc (4) or a cylinder jacket segment, with their emission directions (5, 6) being directed approximately to the center of the circular arc (4) or approximately to the axis of the cylinder jacket segment, the optics (9, 21) being a reflector optics disposed close to the center of the circular arc (4) or the axis of the cylinder jacket segment of the emission directions (5, 6).

11. Diode laser configuration according to claim 10, **characterized in that** the reflector optics (9, 21) comprises one individual mirror (10; 23, 24), in particular a plane mirror or a concave cylindrical mirror, along the axis of the cylinder jacket segment for each emission direction (5, 6), wherein each individual mirror (10; 23, 24) is rotated relative to the other through an angle with respect to the axis of the cylinder jacket segment.

12. Diode laser configuration according to claim 11, **characterized in that** the individual mirrors (23, 24) are tilted with respect to each other in the FA direction (Z).

13. Diode laser configuration according to claim 11 or 12, **characterized in that** the individual mirrors (10; 23, 24) are combined into a monolithic or quasi monolithic mirror configuration.

14. Diode laser configuration according to any one of the claims 11 through 13, **characterized in that** the individual mirrors (10; 23, 24) or the mirror configuration consist of diamond-milled copper or glass with a dielectric highly-reflecting coating.

15. Diode laser configuration according to claim 10, **characterized in that** the reflector optics is formed by a diffractive optical element.

## Revendications

1. Dispositif laser à diodes (2; 2') avec plusieurs barreaux laser (3 ; 17, 18) juxtaposés le long d'un arc dont les directions d'émission (5, 6) sont dirigées vers l'intérieur de l'arc,
**caractérisé en ce**
**que** les barreaux laser (3 ; 17, 18) sont disposés avec leur direction SA le long de l'arc et qu'au moins quelques-uns, de préférence tous les barreaux laser (3 ; 17, 18) sont décalés dans leur direction FA (Z) par rapport à tous les barreaux laser adjacents dans la direction de l'arc et/ou les directions d'émission d'au moins quelques-uns, de préférence de tous les barreaux laser (3 ; 17, 18) sont désalignées les une par rapport aux autres dans leur direction FA (Z).

2. Dispositif laser à diodes selon la revendication 1, **caractérisé en ce qu'**au moins quelques-uns, de préférence tous les barreaux laser (3 ; 17, 18) sont décalés en gradins les uns par rapport aux autres dans leur direction FA (Z).

3. Dispositif laser à diodes selon la revendication 1 ou 2, **caractérisé en ce qu'**au moins un premier élément optique, en particulier une lentille cylindrique (22), est disposé dans le trajet des rayons après lesdits quelques-uns, de préférence tous les barreaux laser (3 ; 17, 18) pour désaligner les directions d'émission.

4. Dispositif laser à diodes selon l'une des revendications précédentes, **caractérisé en ce qu'**au moins quelques-uns, de préférence tous les barreaux laser (3 ; 17, 18) sont disposés le long d'un arc de cercle (4) ou d'un segment d'enveloppe cylindrique et leurs directions d'émission (5, 6) sont orientées approximativement vers le centre de l'arc de cercle (4) ou approximativement vers l'axe du segment d'enveloppe cylindrique.

5. Dispositif laser à diodes selon l'une des revendications précédentes, **caractérisé en ce qu'**au moins quelques-uns, de préférence tous les barreaux laser (3 ; 17, 18) sont montés sur un refroidisseur (15) commun.

6. Dispositif laser à diodes selon la revendication 5, **caractérisé en ce que** la liaison entre les barreaux laser (3 ; 17, 18) et le refroidisseur (15) est réalisée par l'intermédiaire de dissipateurs thermiques (25) identiques, en particulier en cuivre.

7. Dispositif laser à diodes selon la revendication 5 ou 6, **caractérisé en ce que** le refroidisseur comprend une surface d'appui pour chacun de ses barreaux laser (3 ; 17, 18), en particulier au moins quelques-unes des surfaces d'appui étant désalignées les unes par rapport aux autres.

8. Dispositif laser à diodes selon la revendication 6 ou 7, **caractérisé en ce que** du fait de la forme des surfaces d'appui et/ou des dissipateurs thermiques, des longueurs de chemin thermique approximativement identiques sont définies entre les barreaux laser (3 ; 17, 18) et le refroidisseur (15) pour tous les barreaux laser (3 ; 17, 18).

9. Dispositif laser à diodes selon l'une des revendications précédentes, **caractérisé par** au moins une optique (9, 21) qui concentre les directions d'émission (5, 6) des barreaux laser (3 ; 17, 18) en une direction d'émission (11) commune.

10. Dispositif laser à diodes selon la revendication 9, **caractérisé en ce qu'**au moins quelques-uns, de préférence tous les barreaux laser (3 ; 17, 18) sont disposés le long d'un arc de cercle (4) ou d'un segment d'enveloppe cylindrique et leurs directions d'émission (5, 6) sont orientées approximativement vers le centre de l'arc de cercle (4) ou approximativement vers l'axe du segment d'enveloppe cylindrique et que l'optique (9, 21) est une optique réfléchissante disposée à proximité du centre de l'arc de cercle (4) ou de l'axe du segment d'enveloppe cylindrique des directions d'émission (5, 6).

11. Dispositif laser à diodes selon la revendication 10, **caractérisé en ce que** l'optique réfléchissante (9, 21) présente suivant l'axe du segment d'enveloppe cylindrique pour chaque direction d'émission (5, 6) un miroir individuel (10 ; 23, 24), en particulier un miroir plan ou un miroir cylindrique concave, les miroirs individuels (10 ; 23, 24) étant chaque fois mutuellement décalés d'un angle par rapport à l'axe du segment d'enveloppe cylindrique.

12. Dispositif laser à diodes selon la revendication 11, **caractérisé en ce que** les miroirs individuels (23, 24) sont désalignés les uns par rapport aux autres dans la direction FA (Z).

13. Dispositif laser à diodes selon la revendication 11 ou 12, **caractérisé en ce que** les miroirs individuels (10 ; 23, 24) sont assemblés en un dispositif de miroirs monolithique ou quasi monolithique.

14. Dispositif laser à diodes selon l'une des revendications 11 à 13, **caractérisé en ce que** les miroirs individuels (10 ; 23, 24) ou le dispositif de miroirs sont en cuivre fraisé au diamant ou en verre revêtu d'une couche à haute réflexion diélectrique.

15. Dispositif laser à diodes selon la revendication 10, **caractérisé en ce que** l'optique réfléchissante est formée par un élément optique diffractif.
